(19) Europäisches Patentamt
European Patent Office
Office européen des brevets

(11) **EP 4 451 646 A1**

(12) **EUROPEAN PATENT APPLICATION**

(43) Date of publication:
**23.10.2024 Bulletin 2024/43**

(21) Application number: **24161255.5**

(22) Date of filing: **04.03.2024**

(51) International Patent Classification (IPC):
**H04L 67/12** (2022.01)  **H03M 7/30** (2006.01)
**H04L 69/04** (2022.01)  **H04W 4/38** (2018.01)
**H04W 4/70** (2018.01)

(52) Cooperative Patent Classification (CPC):
**H04L 67/12; H03M 7/6047; H03M 7/6052;
H03M 7/607; H04W 4/38; H04W 4/70;** H04L 69/04

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.04.2023  US 202363497472 P**

(71) Applicant: **Ademco, Inc.
Golden Valley, MN 55422 (US)**

(72) Inventors:
• **ARANA, Alejandro
  31350 Chihuahua (MX)**
• **CHAPARRO, Adrian
  31416 Chihuahua (MX)**
• **BOEHMER, Robert
  Golden Valley, 55442 (US)**

(74) Representative: **Murgitroyd & Company
165-169 Scotland Street
Glasgow G5 8PL (GB)**

(54) **COMPUTERIZED SYSTEMS AND METHODS FOR COMPRESSED DATA COMMUNICATION BETWEEN DEVICES FOR A SPECIFICALLY CONFIGURED NETWORK**

(57) Disclosed are systems and methods that provide a communication framework that enables computerized functionality for a climate system's improved operation. The disclosed framework enables a location's climate system to be controlled via a centralized hub, which can be accessed remotely using a mobile application or web interface. The enabled communication network and functionality enables dynamic monitoring and control of the devices/components of a location's climate system, which can be effectuated from anywhere (e.g., at the location or away from the location), providing functionality for increased flexibility and convenience. The disclosed communication framework provides a reliable and secure wireless communication platform for climate system components, enabling improved energy efficiency, comfort and control for residential and commercial locations (e.g., buildings).

EP 4 451 646 A1

**Description**

FIELD OF THE DISCLOSURE

The present disclosure is generally related to a thermostat control system, and more particularly, to a decision intelligence (DI)-based computerized framework for management and control of communications to/from devices of a specifically configured climate control system.

BACKGROUND

Conventional heating, cooling and ventilating (HVAC) systems and baseboard systems (referred to as climate or climate-control systems, used interchangeably) are tasked with performing climate control for a location (e.g., a building, home, office, and the like, for example). Such systems rely on communication networks at the location to rely data/metadata related to the devices operating as part of the climate system.

SUMMARY OF THE DISCLOSURE

Conventional communication networks such climate systems rely on, however, are devoid of the requisite technical capabilities the systems need to adequately detect, relay and/or store system data so as to properly and efficiently operate the climate system at the location. For example, current communication networks (or communication systems, used interchangeably) may not provide the necessary throughput needed to transmit data from one device to another. For example, an outdoor air conditioning (AC) unit may be unable to timely communicate with the indoor furnace and/or the thermostat(s) controlling the climate system at the location.

Therefore, the disclosed systems and methods provide an improved communication framework that enables computerized functionality for a climate system's improved operation. According to some embodiments, the disclosed framework enables a location's climate system to be controlled via a centralized hub, which can be accessed remotely using a mobile application or web interface. As discussed herein, the enabled communication network and functionality enables dynamic monitoring and control of the devices/components of a location's climate system, which can be effectuated from anywhere (e.g., at the location or away from the location), providing functionality for increased flexibility and convenience. Moreover, the disclosed communication framework provides a reliable and secure wireless communication platform for climate system components, enabling improved energy efficiency, comfort and control for residential and commercial locations (e.g., buildings).

Accordingly, while the discussion herein may focus on climate systems and such system's included components/devices, it should not be construed as limiting, as one of skill in the art would readily understand the disclosed systems and methods discussed herein are applicable to other types of systems operating at a location, such as, but not limited to, Internet of Things (IoT) systems, security systems, and the like, without departing from the scope of the instant disclosure.

According to some embodiments, a method is disclosed for management and control of communications to/from devices of a specifically configured climate control system. In accordance with some embodiments, the present disclosure provides a non-transitory computer-readable storage medium for carrying out the above-mentioned technical steps of the framework's functionality. The non-transitory computer-readable storage medium has tangibly stored thereon, or tangibly encoded thereon, computer readable instructions that when executed by a device cause at least one processor to perform a method for management and control of communications to/from devices of a specifically configured climate control system.

In accordance with some embodiments, a system is provided that includes one or more processors and/or computing devices configured to provide functionality in accordance with such embodiments. In accordance with one or more embodiments, functionality is embodied in steps of a method performed by at least one computing device. In accordance with one or more embodiments, program code (or program logic) executed by a processor(s) of a computing device to implement functionality in accordance with one or more such embodiments is embodied in, by and/or on a non-transitory computer-readable medium.

DESCRIPTIONS OF THE DRAWINGS

The features, and advantages of the disclosure will be apparent from the following description of embodiments as illustrated in the accompanying drawings, in which reference characters refer to the same parts throughout the various views. The drawings are not necessarily to scale, emphasis instead being placed upon illustrating principles of the disclosure:

FIG. 1 is a block diagram of an example configuration within which the systems and methods disclosed herein could be implemented according to some embodiments of the present disclosure;

FIG. 2 is a block diagram illustrating components of an exemplary system according to some embodiments of the present disclosure;

FIG. 3 illustrates an exemplary workflow according to some embodiments of the present disclosure;

FIG. 4 depicts an exemplary implementation of an architecture according to some embodiments of the present disclosure;

FIG. 5 depicts an exemplary implementation of an architecture according to some embodiments of the present disclosure; and

FIG. 6 is a block diagram illustrating a computing device showing an example of a client or server device used in various embodiments of the present disclosure.

DETAILED DESCRIPTION

The present disclosure will now be described more fully hereinafter with reference to the accompanying drawings, which form a part hereof, and which show, by way of non-limiting illustration, certain example embodiments. Subject matter may, however, be embodied in a variety of different forms and, therefore, covered or claimed subject matter is intended to be construed as not being limited to any example embodiments set forth herein; example embodiments are provided merely to be illustrative. Likewise, a reasonably broad scope for claimed or covered subject matter is intended. Among other things, for example, subject matter may be embodied as methods, devices, components, or systems. Accordingly, embodiments may, for example, take the form of hardware, software, firmware or any combination thereof (other than software per se). The following detailed description is, therefore, not intended to be taken in a limiting sense.

Throughout the specification and claims, terms may have nuanced meanings suggested or implied in context beyond an explicitly stated meaning. Likewise, the phrase "in one embodiment" as used herein does not necessarily refer to the same embodiment and the phrase "in another embodiment" as used herein does not necessarily refer to a different embodiment. It is intended, for example, that claimed subject matter include combinations of example embodiments in whole or in part.

In general, terminology may be understood at least in part from usage in context. For example, terms, such as "and", "or", or "and/or," as used herein may include a variety of meanings that may depend at least in part upon the context in which such terms are used. Typically, "or" if used to associate a list, such as A, B or C, is intended to mean A, B, and C, here used in the inclusive sense, as well as A, B or C, here used in the exclusive sense. In addition, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

The present disclosure is described below with reference to block diagrams and operational illustrations of methods and devices. It is understood that each block of the block diagrams or operational illustrations, and combinations of blocks in the block diagrams or operational illustrations, can be implemented by means of analog or digital hardware and computer program instructions. These computer program instructions can be provided to a processor of a general purpose computer to alter its function as detailed herein, a special purpose computer, ASIC, or other programmable data processing apparatus, such that the instructions, which execute via the processor of the computer or other programmable data processing apparatus, implement the functions/acts specified in the block diagrams or operational block or blocks. In some alternate implementations, the functions/acts noted in the blocks can occur out of the order noted in the operational illustrations. For example, two blocks shown in succession can in fact be executed substantially concurrently or the blocks can sometimes be executed in the reverse order, depending upon the functionality/acts involved.

For the purposes of this disclosure a non-transitory computer readable medium (or computer-readable storage medium/media) stores computer data, which data can include computer program code (or computer-executable instructions) that is executable by a computer, in machine readable form. By way of example, and not limitation, a computer readable medium may include computer readable storage media, for tangible or fixed storage of data, or communication media for transient interpretation of code-containing signals. Computer readable storage media, as used herein, refers to physical or tangible storage (as opposed to signals) and includes without limitation volatile and non-volatile, removable and non-removable media implemented in any method or technology for the tangible storage of information such as computer-readable instructions, data structures, program modules or other data. Computer readable storage media includes, but is not limited to, RAM, ROM, EPROM, EEPROM, flash memory or other solid state memory technology, optical storage, cloud storage, magnetic storage devices, or any other physical or material medium which can be used to tangibly store the desired information or data or instructions and which can be accessed by a computer or processor.

For the purposes of this disclosure the term "server" should be understood to refer to a service point which provides processing, database, and communication facilities. By way of example, and not limitation, the term "server" can refer to a single, physical processor with associated communications and data storage and database facilities, or it can refer to a networked or clustered complex of processors and associated network and storage devices, as well as operating software and one or more database systems and application software that support the services provided by the server. Cloud servers are examples.

For the purposes of this disclosure a "network" should be understood to refer to a network that may couple devices so that communications may be exchanged, such as between a server and a client device or other types of devices, including between wireless devices coupled via a wireless network, for example. A network may also include mass storage, such as network attached storage (NAS), a storage area network (SAN), a content delivery network (CDN) or other forms of computer or machine-readable media, for example. A network may include the Internet, one or more local area networks (LANs), one or more wide area networks (WANs), wire-line type connections, wireless type connections, cellular or any combination thereof. Likewise, sub-networks, which may employ differing architectures or may be compliant or compatible with differing protocols, may interoperate within a larger network.

For purposes of this disclosure, a "wireless network" should be understood to couple client devices with a network. A wireless network may employ stand-alone ad-hoc networks, mesh networks, Wireless LAN (WLAN) networks, cellular networks, or the like. A wireless network may further employ a plurality of network access technologies, including Wi-Fi, Long Term Evolution (LTE), WLAN, Wireless Router mesh, or 2nd, 3rd, 4th or 5th generation (2G, 3G, 4G or 5G) cellular technology, mobile edge computing (MEC), Bluetooth, 802.11b/g/n, or the like. Network access technologies may enable wide area coverage for devices, such as client devices with varying degrees of mobility, for example.

In short, a wireless network may include virtually any type of wireless communication mechanism by which signals may be communicated between devices, such as a client device or a computing device, between or within a network, or the like.

A computing device may be capable of sending or receiving signals, such as via a wired or wireless network, or may be capable of processing or storing signals, such as in memory as physical memory states, and may, therefore, operate as a server. Thus, devices capable of operating as a server may include, as examples, dedicated rack-mounted servers, desktop computers, laptop computers, set top boxes, integrated devices combining various features, such as two or more features of the foregoing devices, or the like.

For purposes of this disclosure, a client (or user, entity, subscriber or customer) device may include a computing device capable of sending or receiving signals, such as via a wired or a wireless network. A client device may, for example, include a desktop computer or a portable device, such as a cellular telephone, a smart phone, a display pager, a radio frequency (RF) device, an infrared (IR) device a Near Field Communication (NFC) device, a Personal Digital Assistant (PDA), a handheld computer, a tablet computer, a phablet, a laptop computer, a set top box, a wearable computer, smart watch, an integrated or distributed device combining various features, such as features of the forgoing devices, or the like.

A client device may vary in terms of capabilities or features. Claimed subject matter is intended to cover a wide range of potential variations, such as a web-enabled client device or previously mentioned devices may include a high-resolution screen (HD or 4K for example), one or more physical or virtual keyboards, mass storage, one or more accelerometers, one or more gyroscopes, global positioning system (GPS) or other location-identifying type capability, or a display with a high degree of functionality, such as a touch-sensitive color 2D or 3D display, for example.

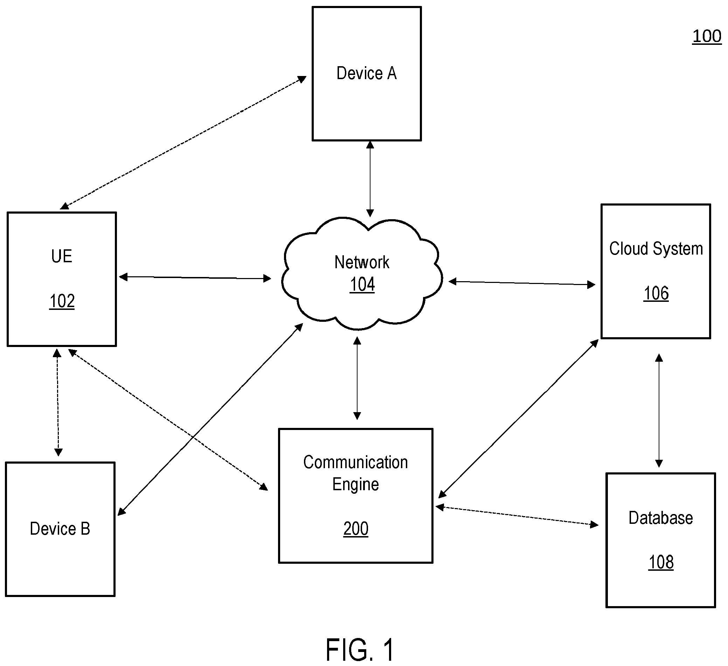

Certain embodiments and principles will be discussed in more detail with reference to the figures. With reference to FIG. 1, system 100 is depicted which includes user equipment (UE) 102 (e.g., a client device, as mentioned above and discussed below in relation to FIG. 7), Device A, Device B, network 104, cloud system 106, database 108 and communication engine 200. It should be understood that while system 100 is depicted as including such components, it should not be construed as limiting, as one of ordinary skill in the art would readily understand that varying numbers of UEs, devices (e.g., Devices C, D,... *n*), cloud systems, databases and networks can be utilized; however, for purposes of explanation, system 100 is discussed in relation to the example depiction in FIG. 1.

According to some embodiments, UE 102 can be any type of device, such as, but not limited to, a mobile phone, tablet, laptop, sensor, IoT device, autonomous machine, and any other device equipped with a cellular or wireless or wired transceiver. In some embodiments, UE 102 can be a device associated with an individual (or set of individuals) for which disclosed services are being provided. In some embodiments, UE 102 may correspond to a device of a HVAC or climate-control related entity (e.g., a HVAC provider, whereby the device can be and/or can have corresponding sensors 110, as discussed herein). Thus, according to some embodiments, UE 102 can correspond to a thermostat operating at a location (e.g., a home or office).

In some embodiments, a peripheral device (not shown) can be connected to UE 102, and can be any type of peripheral device, such as, but not limited to, a wearable device (e.g., smart watch), printer, speaker, sensor, and the like. In some embodiments, peripheral device can be any type of device that is connectable to UE 102 via any type of known or to be known pairing mechanism, including, but not limited to, Bluetooth™, Bluetooth Low Energy (BLE), NFC, and the like.

According to some embodiments, Device A and Device B can each correspond to a device at a location that provide climate and/or security capabilities. For example, Device A can be an outdoor air conditioning (AC) unit, and Device B can be a furnace. In another non-limiting example, Device A can be a fan within a room of a home, and Device B can be a sensor (e.g., motion sensor associated with the room, for example). Accordingly, any type of known or to be known device that can be part of and/or utilized by a climate system (and/or security system) of a location can be represented by Device A and/or Device. B.

In some embodiments, for example, Device A and/or B can be a device associated with an HVAC system, such as, but not limited to, an AC unit, furnace, heat pump, air handler, humidifier, dehumidifier, ventilation system, zone control system, and the like.

In some embodiments, for example, Device A and/or Device B can correspond to sensors and/or activators at a location that can collect and/or provide data to the HVAC components. For example, such devices can include, but are not limited to, cameras, glass break detectors, motion detectors, door and window contacts, heat and smoke detectors, carbon monoxide ($CO_2$) detectors, passive infrared (PIR) sensors, lights, smart locks, garage doors, smart appliances (e.g., thermostat, refrigerator, television, personal assistants (e.g., Alexa®, Nest®, for example)), smart phones, smart watches or other wearables, tablets, personal computers, and the like, and some combination thereof. Thus, the Device A and/or B can be, wholly or in part, associated with and/or part of an IoT sensor network.

In some embodiments, network 104 can be any type of network, such as, but not limited to, a wireless network, cellular network, the Internet, and the like (as discussed above). Network 104 facilitates connectivity of the components of system 100, as illustrated in FIG. 1. In some embodiments, network 104 can be a specifically configured and/or enabled communication network, such as, for example, RedLINK™ communication platform. For example, such specific network can enable communication between various devices and components within an HVAC system, thereby allowing for improved energy efficiency, comfort, and control.

In some embodiments, such specifically configured network can include UE 102, Device A and Device B - for example, RedLINK devices can include, but are not limited to, thermostats, air sensors, and other HVAC components that can communicate wirelessly with each other using encrypted signals. As discussed herein, such enabled communication can allow the devices to exchange information and adjust their operation based on various factors such as occupancy, temperature, humidity, and outdoor weather conditions, and the like.

According to some embodiments, cloud system 106 may be any type of cloud operating platform and/or network based system upon which applications, operations, and/or other forms of network resources may be located. For example, system 106 may be a service provider and/or network provider from where services and/or applications may be accessed, sourced or executed from. For example, system 106 can represent the cloud-based architecture associated with a climate control system provider, which has associated network resources hosted on the internet or private network (e.g., network 104), which enables (via engine 200) the communication/climate management discussed herein.

In some embodiments, cloud system 106 may include a server(s) and/or a database of information which is accessible over network 104. In some embodiments, a database 108 of cloud system 106 may store a dataset of data and metadata associated with local and/or network information related to a user(s) of UE 102, Device A and/or Device B, UE 102, Device A and Device B, and the services and applications provided by cloud system 106 and/or communication engine 200.

In some embodiments, for example, cloud system 106 can provide a private/proprietary climate management platform, whereby engine 200, discussed *infra,* corresponds to the novel functionality system 106 enables, hosts and provides to a network 104 and other devices/sensors/platforms operating thereon.

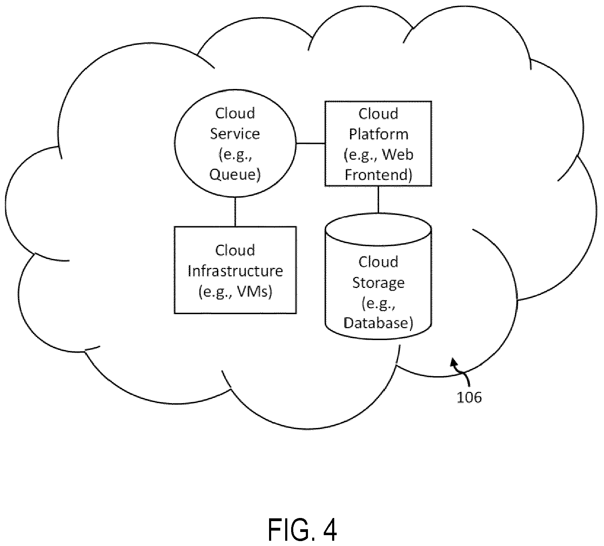

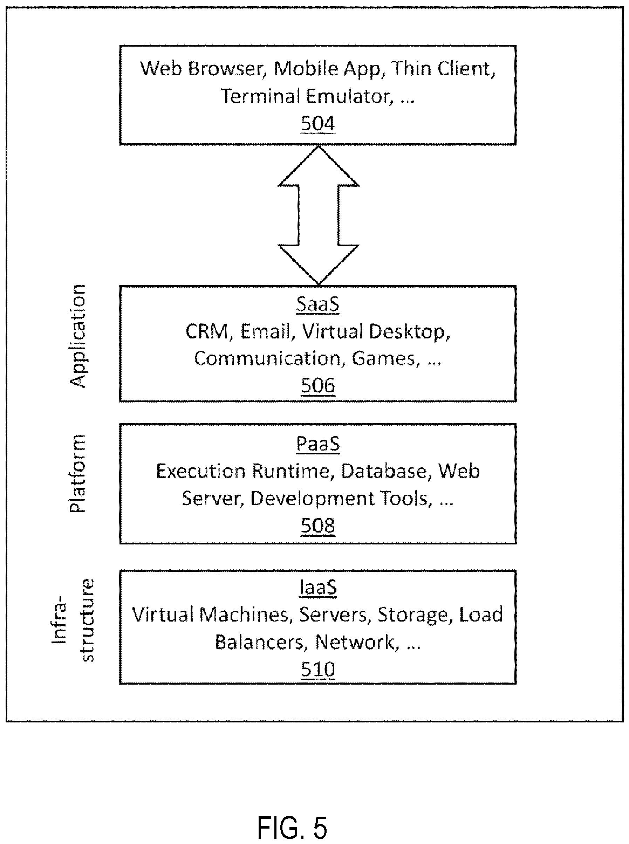

Turning to FIG. 4 and FIG. 5, in some embodiments, the exemplary computer-based systems/platforms, the exemplary computer-based devices, and/or the exemplary computer-based components of the present disclosure may be specifically configured to operate in a cloud computing/architecture 106 such as, but not limiting to: infrastructure a service (IaaS) 510, platform as a service (PaaS) 508, and/or software as a service (SaaS) 506 using a web browser, mobile app, thin client, terminal emulator or other endpoint 504. FIG. 4 and FIG. 5 illustrate schematics of non-limiting implementations of the cloud computing/architecture(s) in which the exemplary computer-based systems for administrative customizations and control of network-hosted application program interfaces (APIs) of the present disclosure may be specifically configured to operate.

Turning back to FIG. 1, according to some embodiments, database 108 may correspond to a data storage for a platform (e.g., a network hosted platform, such as cloud system 106, as discussed *supra*), a plurality of platforms, and/or UE 102 and/or sensors 110. Database 108 may receive storage instructions/requests from, for example, engine 200 (and associated microservices), which may be in any type of known or to be known format, such as, for example, standard query language (SQL). According to some embodiments, database 108 may correspond to any type of known or to be known storage, for example, a memory or memory stack of a device, a distributed ledger of a distributed network (e.g., blockchain, for example), a look-up table (LUT), and/or any other type of secure data repository.

Communication engine 200, as discussed above and further below in more detail, can include components for the disclosed functionality. According to some embodiments, communication engine 200 may be a special purpose machine or processor, and can be hosted by a device on network 104, within cloud system 106 and/or on UE 102 (and/or peripheral device 112). In some embodiments, engine 200 may be hosted by a server and/or set of servers associated with cloud system 106.

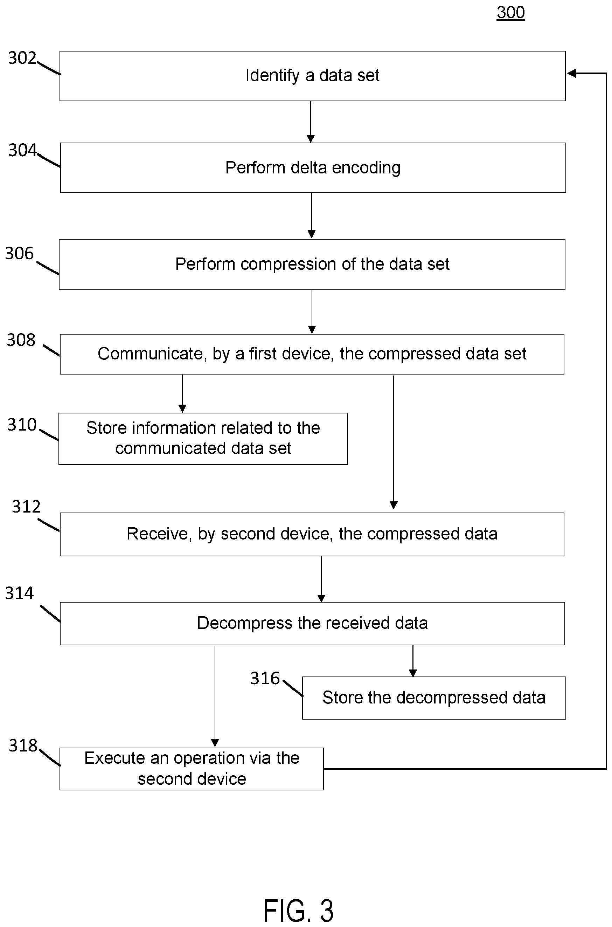

According to some embodiments, as discussed in more detail below, communication engine 200 may be configured to implement and/or control a plurality of services and/or microservices, where each of the plurality of services/microservices are configured to execute a plurality of workflows associated with performing the disclosed communication and/or climate management. Non-limiting embodiments of such workflows are provided below in relation to at least FIG. 3.

According to some embodiments, as discussed above, communication engine 200 may function as an application provided by cloud system 106. In some embodiments, engine 200 may function as an application installed on a server(s), network location and/or other type of network resource associated with system 106. In some embodiments, engine 200 may function as application installed and/or executing on UE 102. In some embodiments, such application may be a web-based application accessed by UE 102 and/or devices associated with sensors 110 over network 104 from cloud system 106. In some embodiments, engine 200 may be configured and/or installed as an augmenting script, program or application (e.g., a plug-in or extension) to another application or program provided by cloud system 106 and/or executing on UE 102 and/or sensors 110.

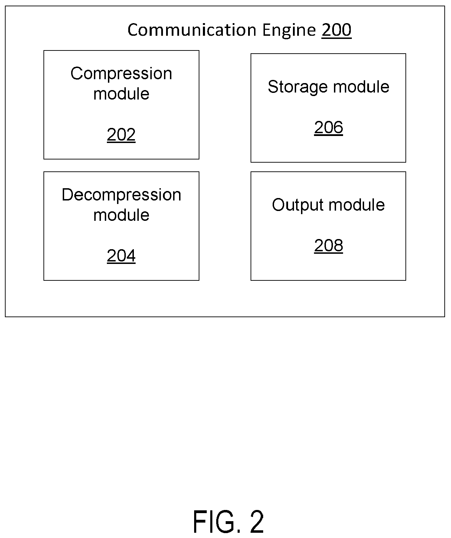

As illustrated in FIG. 2, according to some embodiments, communication engine 200 includes compression module 202, decompression module 204, storage module 206 and output module 208. It should be understood that the engine(s) and modules discussed herein are non-exhaustive, as additional or fewer engines and/or modules (or submodules) may be applicable to the embodiments of the systems and methods discussed. More detail of the operations, configurations and functionalities of engine 200 and each of its modules, and their role within embodiments of the present disclosure will be discussed below.

Turning to FIG. 3, Process 300 provides non-limiting example embodiments for the disclosed communication management framework. In some embodiments, as discussed herein, the disclosed framework provides functionality for a reliable and secure wireless communication platform for an IoT system (e.g., climate system, for example).

According to some embodiments, Steps 302-306 of Process 300 can be performed by compression module 202 of communication engine 200; Steps 308 and 318 can be performed by output module 208; Steps 310 and 316 can be performed by storage module 206; and Steps 312-314 can be performed by decompression module 314.

According to some embodiments, Process 300 begins with Step 302 where engine 200 identifies a data set (e.g., a set of data). According to some embodiments, the data set can correspond to data and/or metadata associated with a climate system. In some embodiments, the data set can correspond to data collected and/or generated by a first device - for example, operational data of Device A within system 100, as discussed above in relation to FIG. 1. In some embodiments, the data set can correspond to data measurements of a first device, which can be performed according to a predetermined time period (e.g., during time $x$ to time $y$, during operation of the first device, and the like).

In some embodiments, the data set can be sampled upon identification. In some embodiments, such sampling can be executed by engine 200 executing any type of known or to be known sampling algorithm or mechanism, for example, uniform random sampling, stratified sampling, importance sampling, Markov Chain Monte Carlo (MCM) sampling, and the like.

In Step 304, engine 200 can perform data encoding. In some embodiments, such encoding can be performed based on the identified set, whereby the above mentioned data sampling can be performed therefrom; and in some embodiments, such encoding can be performed on the sampled data set.

According to some embodiments, prior to the compression (in Step 306, discussed *infra*), the data set is first delta-encoded. According to some embodiments, delta encoding includes calculating the difference between consecutive values. These deltas can be the actual data that is compressed. Accordingly, delta encoding provides functionality for minimizing the number of bits required to represent a value when consecutive data values are comparable in magnitude.

Delta encoding N samples, data[0..N-1]:

$$\text{delta}[0] = \text{data}[0]$$

$$\text{delta}[n] = \text{data}[n] - \text{data}[n\text{-}1], \, n = 1..N\text{-}1$$

According to some embodiments, engine 200 can implement any type of known or to be known delta encoding, which can include, but is not limited to, delta encoding with fixed-width integers, delta encoding with variable-width-integers, Golomb-Rice encoding, Elias delta encoding, binary delta encoding, and the like, for example.

In Step 306, engine 200 can perform compression of the data set, which as discussed herein, can be based on the delta encoding performed in Step 304. According to some embodiments, engine 200 can perform any type of known or to be known lossless or lossy compression algorithm or technique. In some embodiments, the compression can be based on the data value, whereby the configuration and sequence of the data set (or data samples) can be defined, which can enable a proper representation of the data for communication, as discussed below.

Thus, according to some embodiments, Step 306 can involve compressing the encoded data set (or data samples, in some embodiments) into a data value. In some embodiments, the data value and/or set of data values can be determined, which can include information related to, a configuration of a data set and/or data samples, a sequence of the data set and/or data samples, a size of the data set and/or data samples, a word/words size, and the like, or some combination thereof. In some embodiments, the compression can be in accordance with a variable storage element size and/or a static code word size, as discussed below.

By way of a non-limiting example, depicted below in Table 1 are compression results for the first 60 seconds of data. In the example, the encoding can correspond to 240 bytes while an original 16-bit samples required 496 bytes yielding a compression ratio of 51.6%.

- Sample: zero based sample number
- First Device (e.g., Furnace, for example) Current: appliance current extracted from cloud data (e.g., cloud system 106 - for example, TwinThread)
- 16-bit Values: calculated 16-bit value for Furnace Current
- Delta Encoding: the delta encoded 16-bit values
- Required bits: minimum field width required to store Delta Encoding value
- Compressed Bytes: number of bytes being used to encode value(s)
- Encoding Mode: compression mode encoded in "Code" field
- Encoded Sample: number of sample inside encoded Data field

Table 1:

| Sample | Furnace Current | 16-bit Values | Delta Encoding | Required Bits | Compressed Bytes | Encoding Mode | Encoded Sample |
|---|---|---|---|---|---|---|---|
| 0 | 0.139 | 88 | 88 | 7 | 2 | 12-bits | 1 |
| 1 | 0.139 | 88 | 0 | 1 | | | 1 |
| 2 | 0.139 | 88 | 0 | 1 | | | 2 |
| 3 | 0.139 | 88 | 0 | 1 | | | 3 |
| 4 | 0.139 | 88 | 0 | 1 | | | 4 |
| 5 | 0.139 | 88 | 0 | 1 | 2 | zeroes | 5 |
| 6 | 0.139 | 88 | 0 | 1 | | | 6 |
| 7 | 0.139 | 88 | 0 | 1 | | | 7 |
| 8 | 0.139 | 88 | 0 | 1 | | | 8 |
| 9 | 0.139 | 88 | 0 | 1 | | | 9 |
| 10 | 0.159 | 101 | 13 | 4 | 4 | 14-bits | 1 |
| 11 | 15.514 | 9928 | 9827 | 14 | | | 2 |
| 12 | 10.736 | 6871 | -3057 | 12 | 4 | 14-bits | 1 |
| 13 | 8.784 | 5621 | -1250 | 11 | | | 2 |
| 14 | 8.759 | 5605 | -16 | 5 | | | 1 |
| 15 | 8.706 | 5571 | -34 | 6 | 4 | 7-bits | 2 |
| 16 | 8.805 | 5635 | 64 | 7 | | | 3 |
| 17 | 8.775 | 5616 | -19 | 5 | | | 4 |

(continued)

| Sample | Furnace Current | 16-bit Values | Delta Encoding | Required Bits | Compressed Bytes | Encoding Mode | Encoded Sample |
|---|---|---|---|---|---|---|---|
| 18 | 8.825 | 5648 | 32 | 6 | | | 1 |
| 19 | 8.795 | 5628 | -20 | 5 | 4 | 7-bits | 2 |
| 20 | 8.795 | 5628 | 0 | 1 | | | 3 |
| 21 | 8.752 | 5601 | -27 | 5 | | | 4 |
| 22 | 8.769 | 5612 | 11 | 4 | | | 1 |
| 23 | 8.769 | 5612 | 0 | 1 | | | 2 |
| 24 | 8.809 | 5637 | 25 | 5 | 4 | 5-bits | 3 |
| 25 | 8.798 | 5630 | -7 | 3 | | | 4 |
| 26 | 8.78 | 5619 | -11 | 4 | | | 5 |
| 27 | 8.713 | 5576 | -43 | 6 | 4 | 7-bits | 1 |
| 28 | 8.78 | 5619 | 43 | 6 | | | 2 |
| 29 | 8.736 | 5591 | -28 | 5 | | | 3 |
| 30 | 8.773 | 5614 | 23 | 5 | | | 4 |
| 31 | 8.727 | 5585 | -29 | 5 | | | 1 |
| 32 | 8.745 | 5596 | 11 | 4 | | | 2 |
| 33 | 8.73 | 5587 | -9 | 4 | 4 | 5-bits | 3 |
| 34 | 8.73 | 5587 | 0 | 1 | | | 4 |
| 35 | 8.73 | 5587 | 0 | 1 | | | 5 |
| 36 | 8.786 | 5623 | 36 | 6 | | | 1 |
| 37 | 8.745 | 5596 | -27 | 5 | 4 | 7-bits | 2 |
| 38 | 8.745 | 5596 | 0 | 1 | | | 3 |
| 39 | 8.761 | 5607 | 11 | 4 | | | 4 |
| 40 | 8.772 | 5614 | 7 | 3 | | | 1 |
| 41 | 8.736 | 5591 | -23 | 5 | 4 | 7-bits | 2 |
| 42 | 8.756 | 5603 | 12 | 4 | | | 3 |
| 43 | 8.766 | 5610 | 7 | 3 | | | 4 |
| 44 | 8.714 | 5576 | -34 | 6 | | | 1 |
| 45 | 8.714 | 5576 | 0 | 1 | 4 | 7-bits | 2 |
| 46 | 8.745 | 5596 | 20 | 5 | | | 3 |
| 47 | 8.753 | 5601 | 5 | 3 | | | 4 |
| 48 | 8.723 | 5582 | -19 | 5 | | | 1 |
| 49 | 8.723 | 5582 | 0 | 1 | | | 2 |
| 50 | 8.723 | 5582 | 0 | 1 | 4 | 5-bits | 3 |
| 51 | 8.734 | 5589 | 7 | 3 | | | 4 |
| 52 | 8.688 | 5560 | -29 | 5 | | | 5 |
| 53 | 8.719 | 5580 | 20 | 5 | 4 | 7-bits | 1 |
| 54 | 8.703 | 5569 | -11 | 4 | | | 2 |

(continued)

| Sample | Furnace Current | 16-bit Values | Delta Encoding | Required Bits | Compressed Bytes | Encoding Mode | Encoded Sample |
|---|---|---|---|---|---|---|---|
| 55 | 8.728 | 5585 | 16 | 5 | | | 3 |
| 56 | 8.691 | 5562 | -23 | 5 | | | 4 |
| 57 | 8.759 | 5605 | 43 | 6 | 4 | 9-bits | 1 |
| 58 | 8.684 | 5557 | -48 | 6 | | | 2 |
| 59 | 8.739 | 5592 | 35 | 6 | | | 3 |

In Step 308, engine 200 can communicate the compressed data. For example, the communication can involve the determined data value. In some embodiments, the communication can be from a first device to a second device. In some embodiments, for example, the first device can be UE 102 in system 100 (where the data is associated with collected information from Device A), whereby the second device is Device B. In some embodiments, for example, the first device can be Device A, and the second device is Device B (and vice versa).

Accordingly, in some embodiments, such communication can be implemented via network 104, which can be any type of network discussed above.

In Step 310, engine 200, upon communication of the compressed data set (e.g., in parallel or in sequence), can store the information related to the communicate data set (e.g., the compressed data, the data values, and the like). In some embodiments, such storage can be performed with respect to cloud storage (e.g., cloud system 106 and/or database 108, as discussed above); and/or, in some embodiments, the first device (e.g., UE 102 and/or Device A) can store such data.

According to some embodiments, the storage operation performed in Step 310 can involve storage of the data value(s) (e.g., from Step 306, discussed *supra*), where the storage can be based on and/or in accordance with information related to the variable storage element size and the static code word.

According to some embodiments, with reference to Steps 302-310 discussed *supra,* engine 200 can operate a compression algorithm(s) by packing multiple delta encoded data values into a single storage element. For example, a storage element can be a single storage word. For example, storage element sizes can be, for simple encodings: i) simple-8b: 64-bits; ii) simple-9, Simple-16: 32-bits.

According to some embodiments, Simple-RL compression can be used to compress 16-bit signed data. As such, in some embodiments, storage element size can be either 16-bits or 32-bits; and in some embodiments, the code word size can be 4-bits regardless of the storage element size. In some embodiments, if the most significant bit of the code word is 0, then the storage element size can be 32-bits; and if the most significant bit of the code word is 1, then the storage element size can be 16-bits.

In some embodiments, for simple encodings, at least a portion of the bits in the storage element can be utilized to store a code that identifies the size of the data values that are stored in the remainder of the word. Accordingly, in some embodiments, compression can be achieved by storing multiple data values in the storage element using the minimum number of bits possible to represent the data values.

By way of a non-limiting example embodiments, according to some embodiment which can involve RedLINK™ specific components, Steps 302-310 can be executed in a similar, albeit, modified manner. According to some embodiments, as mentioned above, Simple-RL first uses delta encoding on the data to be compressed:

Delta encoding N samples, data[0..N-1]:

$$delta[0] = data[0]$$

$$delta[n] = data[n] - data[n-1], n = 1..N-1.$$

In some embodiments, input samples, data[], are of type uint16_t., and output samples, delta[], are of type int16_t.

According to some embodiments, when an event occurs where the first input sample, data[0] has its most significant bit (b15) set to 1, then delta[0] will be a negative number.

According to some embodiments, each new packet to be sent can generate a new set of delta encoded data.

9

In some embodiments, if data is being encoded every a predetermined number of samples (e.g., 60 samples), the new data can be encoded with delta[0] = data[0]. In some embodiments, for a 60 sample example, data may not be encoded as delta[0] = data[0] - data[59] where data[59] is the 60th sample from the previous message. This, among other benefits, enables the recovery of a message/data upon it being lost, deleted or corrupted, and enables subsequent, sequential messages/data to thereby recovered as well.

Accordingly, in some embodiments, in line with the storage of Step 310, engine 200 can perform a signedness operation, where to be stored data values are stored as signed values using two's complement.

By way of a non-limiting example, for the following 32-bit Encoding:

| Code | | | | Data | |
|------|------|------|------|------|------|
| b31 | b30 | b29 | b28 | b27 | b0 |
| 0 | 0 | 0 | 0 | Quantity 7 4-bit values | |
| 0 | 0 | 0 | 1 | Quantity 6 4-bit values | |
| 0 | 0 | 1 | 0 | Quantity 5 5-bit values | |
| 0 | 0 | 1 | 1 | Quantity 4 7-bit values | |
| 0 | 1 | 0 | 0 | Quantity 3 9-bit values | |
| 0 | 1 | 0 | 1 | Quantity 2 14-bit values | |
| 0 | 1 | 1 | 0 | Quantity 1 16-bit value | |
| 0 | 1 | 1 | 1 | Reserved for future use | |

Table 2 shows an example of how data fields can be allocated within the Data section for each Code value. In Table 2, greyed out cells indicate unused portions of the Data section for the individual Code values, the values are stored beginning with the most significant bits of the Data field, and any bits not used for a particular encoding are the least significant bits of the Data field.

Table 2

| Code | | | | Data Fields | | | | | | |
|------|------|------|------|------|------|------|------|------|------|------|
| b31 | b30 | b29 | b28 | b27 | | | | | | b0 |
| 0 | 0 | 0 | 0 | Value 1 | Value 2 | Value 3 | Value 4 | Value 5 | Value 6 | Value 7 |
| 0 | 0 | 0 | 1 | Value 1 | Value 2 | Value 3 | Value 4 | Value 5 | Value 6 | b3..b0 |
| 0 | 0 | 1 | 0 | Value 1 | Value 2 | Value 3 | Value 4 | Value 5 | b2..b0 | |
| 0 | 0 | 1 | 1 | Value 1 | Value 2 | Value 3 | Value 4 | | | |
| 0 | 1 | 0 | 0 | Value 1 | Value 2 | Value 3 | b0 | | | |
| 0 | 1 | 0 | 1 | Value 1 | Value 2 | | | | | |
| 0 | 1 | 1 | 0 | Value 1 | b11..b0 | | | | | |
| 0 | 1 | 1 | 1 | Reserved for future use | | | | | | |

According to some embodiments, for 32-bit storage elements, there are no exceptions to signedness, as a encoded data is stored as two's complement.

In another non-limiting example, according to some embodiments, for the following 16-bit Encoding:

| Code | | | | Data | |
|------|------|------|------|------|------|
| b15 | b14 | b13 | b12 | b11 | b0 |
| 1 | 0 | 0 | 0 | Number of consecutive zero values | |
| 1 | 0 | 0 | 1 | Quantity 12 1-bit values | |

(continued)

| Code | | | | Data |
|---|---|---|---|---|
| 1 | 0 | 1 | 0 | Quantity 6 2-bit values |
| 1 | 0 | 1 | 1 | Quantity 4 3-bit values |
| 1 | 1 | 0 | 0 | Quantity 3 4-bit values |
| 1 | 1 | 0 | 1 | Quantity 2 6-bit values |
| 1 | 1 | 1 | 0 | Quantity 1 12-bit value |
| 1 | 1 | 1 | 1 | Reserved for future use |

In some embodiments, a primary use for 16-bit encoding is to store a sequence of multiple zero values. Multiple zero values can be encoded by setting the Code field to '1 0 0 0' and then setting the data field to the number of zeroes to be encoded. For example, if there are 15 consecutive zeroes in the data, the data would be encoded as: '1 0 0 0 0 0 0 0 0 0 0 0 1 1 1 1', or 0x800F.

According to some embodiments, Table 3 below shows an example of how data fields can be allocated within the Data section for each Code value. In Table 3, greyed out cells indicate unused portions of the Data section for the individual Code values, values are stored beginning with the most significant bits of the Data field, and any bits not used for a particular encoding are the least significant bits of the Data field.

Table 3:

| Code | | | | Data Fields | | | | | | | | | | | | |
|---|---|---|---|---|---|---|---|---|---|---|---|---|---|---|---|---|
| b15 | b14 | b13 | b12 | b11 | | | | | | | | | | | | b0 |
| 1 | 0 | 0 | 0 | Number of consecutive zero values stored as 12-bit field | | | | | | | | | | | | |
| 1 | 0 | 0 | 1 | vail | | val2 | val3 | val4 | val5 | val6 | val7 | val8 | val9 | val10 | val11 | val12 |
| 1 | 0 | 1 | 0 | value 1 | | | value 2 | | value 3 | | value 4 | | value 5 | | value 6 | |
| 1 | 0 | 1 | 1 | value 1 | | | | value 2 | | | value 3 | | | value 4 | | |
| 1 | 1 | 0 | 0 | value 1 | | | | | value 2 | | | | value 3 | | | |
| 1 | 1 | 0 | 1 | value 1 | | | | | | | value 2 | | | | | |
| 1 | 1 | 1 | 0 | value 1 | | | | | | | | | | | | |
| 1 | 1 | 1 | 1 | Reserved for future use | | | | | | | | | | | | |

According to some embodiments, for 16-bit storage elements, exceptions to signedness may arise. For example, when code '1 0 0 0' is used to encode some number of consecutive zeroes, since zero values are not signed, code '1 0 0 0' does not encode signed values. In another non-limiting example, when code '1 0 0 1' is used to encode 12 consecutive single bit values, since this code can only encode '0' and '1' values, engine 200 would not encode signed values.

Continuing with Process 300, in Step 312, the communicated compressed data can be received. For example, with reference to FIG. 1 discussed *supra,* the receiving device can be Device B or UE 102 for example. For example, if the first device sending the compressed data is Device A or UE 102, then the second device can be Device B.

In Step 314, upon reception of the compressed data, the second device, via execution of engine 200, can decompress the compressed data. According to some embodiments, such decompression can be performed according to any known or to be known decompression technique for decompressing data that was compressed via Step 306, as discussed above. For example, engine 200 can execute a decompression algorithm including, but not limited to, Huffman coding, Run-length encoding (RLE), Arithmetic coding, Lempel-Ziv-Welch (LZW) algorithm, Burrows-Wheeler Transform (BWT), Deflate algorithm, LZ77 algorithm, LZ78 algorithm, LZSS algorithm, Delta encoding, and the like.

According to some embodiments, Step 314 decompression can involve the received data value (from Step 312) being decompressed by the second device upon receipt. Accordingly, in Step 316, the decompressed data value is stored in a buffer associated with the second device. In some embodiments, Step 316 can further involve communicating the decompressed data to cloud storage, as in a similar manner as discussed above at least with respect to Step 310.

In Step 318, engine 200 can cause and/or facilitate operation of the second device based on the data. For example, the second device can operate based on measured data from the first device.

For example, if the second device can be caused to execute a program to offset the measurements of the first device. For example, a furnace (e.g., second device) can execute a heat program/mode for a room upon receiving temperature measurements from an AC unit (first device). In some embodiments, the temperature measurements can be collected and provided from a thermostat acting as the first device, as discussed above.

Accordingly, upon operation of the second device (e.g., Device B, for example), Process 300 can recursively operate to Step 302 so as to identify the data from the second device's operation, which can enable the identification of data related to such operation.

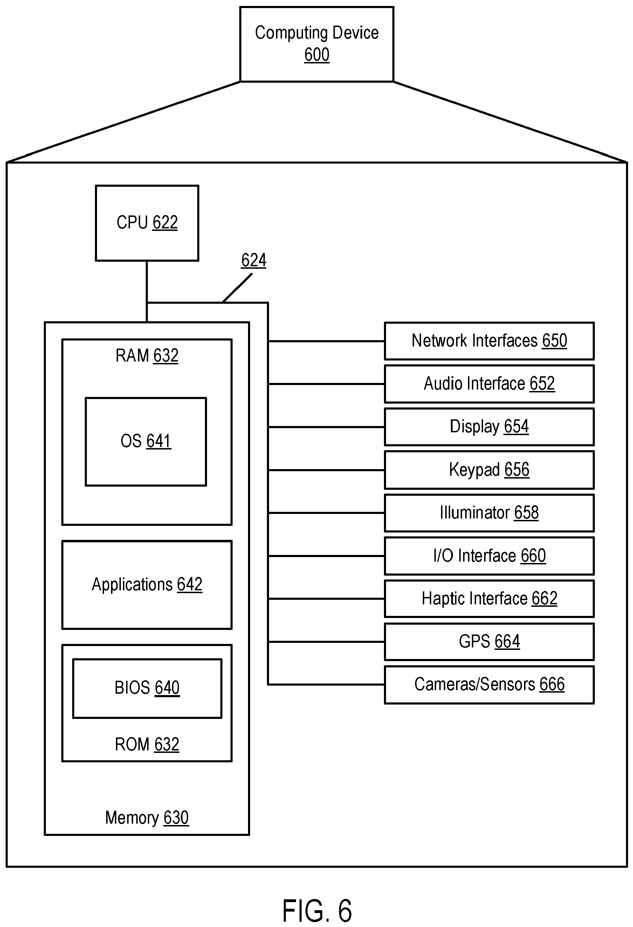

FIG. 6 is a schematic diagram illustrating a client device showing an example embodiment of a client device that may be used within the present disclosure. Client device 600 may include many more or less components than those shown in FIG. 6. However, the components shown are sufficient to disclose an illustrative embodiment for implementing the present disclosure. Client device 600 may represent, for example, UE 102 discussed above at least in relation to FIG. 1.

As shown in the figure, in some embodiments, Client device 600 includes a processing unit (CPU) 622 in communication with a mass memory 630 via a bus 624. Client device 600 also includes a power supply 626, one or more network interfaces 650, an audio interface 652, a display 654, a keypad 656, an illuminator 658, an input/output interface 660, a haptic interface 662, an optional global positioning systems (GPS) receiver 664 and a camera(s) or other optical, thermal or electromagnetic sensors 666. Device 600 can include one camera/sensor 666, or a plurality of cameras/sensors 666, as understood by those of skill in the art. Power supply 626 provides power to Client device 600.

Client device 600 may optionally communicate with a base station (not shown), or directly with another computing device. In some embodiments, network interface 650 is sometimes known as a transceiver, transceiving device, or network interface card (NIC).

Audio interface 652 is arranged to produce and receive audio signals such as the sound of a human voice in some embodiments. Display 654 may be a liquid crystal display (LCD), gas plasma, light emitting diode (LED), or any other type of display used with a computing device. Display 654 may also include a touch sensitive screen arranged to receive input from an object such as a stylus or a digit from a human hand.

Keypad 656 may include any input device arranged to receive input from a user. Illuminator 658 may provide a status indication and/or provide light.

Client device 600 also includes input/output interface 660 for communicating with external. Input/output interface 660 can utilize one or more communication technologies, such as USB, infrared, Bluetooth™, or the like in some embodiments. Haptic interface 662 is arranged to provide tactile feedback to a user of the client device.

Optional GPS transceiver 664 can determine the physical coordinates of Client device 600 on the surface of the Earth, which typically outputs a location as latitude and longitude values. GPS transceiver 664 can also employ other geo-positioning mechanisms, including, but not limited to, triangulation, assisted GPS (AGPS), E-OTD, CI, SAI, ETA, BSS or the like, to further determine the physical location of client device 600 on the surface of the Earth. In one embodiment, however, Client device may through other components, provide other information that may be employed to determine a physical location of the device, including for example, a MAC address, Internet Protocol (IP) address, or the like.

Mass memory 630 includes a RAM 632, a ROM 634, and other storage means. Mass memory 630 illustrates another example of computer storage media for storage of information such as computer readable instructions, data structures, program modules or other data. Mass memory 630 stores a basic input/output system ("BIOS") 640 for controlling low-level operation of Client device 600. The mass memory also stores an operating system 641 for controlling the operation of Client device 600.

Memory 630 further includes one or more data stores, which can be utilized by Client device 600 to store, among other things, applications 642 and/or other information or data. For example, data stores may be employed to store information that describes various capabilities of Client device 600. The information may then be provided to another device based on any of a variety of events, including being sent as part of a header (e.g., index file of the HLS stream) during a communication, sent upon request, or the like. At least a portion of the capability information may also be stored on a disk drive or other storage medium (not shown) within Client device 600.

Applications 642 may include computer executable instructions which, when executed by Client device 600, transmit, receive, and/or otherwise process audio, video, images, and enable telecommunication with a server and/or another user of another client device. Applications 642 may further include a client that is configured to send, to receive, and/or to otherwise process gaming, goods/services and/or other forms of data, messages and content hosted and provided by the platform associated with engine 200 and its affiliates.

As used herein, the terms "computer engine" and "engine" identify at least one software component and/or a combination of at least one software component and at least one hardware component which are designed/programmed/configured to manage/control other software and/or hardware components (such as the libraries, software development kits (SDKs), objects, and the like).

Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth. In some embodiments, the one or more processors may be implemented as a Complex Instruction Set Computer (CISC) or Reduced Instruction Set Computer (RISC) processors; x86 instruction set compatible processors, multicore, or any other microprocessor or central processing unit (CPU). In various implementations, the one or more processors may be dual-core processor(s), dual-core mobile processor(s), and so forth.

Computer-related systems, computer systems, and systems, as used herein, include any combination of hardware and software. Examples of software may include software components, programs, applications, operating system software, middleware, firmware, software modules, routines, subroutines, functions, methods, procedures, software interfaces, API, instruction sets, computer code, computer code segments, words, values, symbols, or any combination thereof. Determining whether an embodiment is implemented using hardware elements and/or software elements may vary in accordance with any number of factors, such as desired computational rate, power levels, heat tolerances, processing cycle budget, input data rates, output data rates, memory resources, data bus speeds and other design or performance constraints.

For the purposes of this disclosure a module is a software, hardware, or firmware (or combinations thereof) system, process or functionality, or component thereof, that performs or facilitates the processes, features, and/or functions described herein (with or without human interaction or augmentation). A module can include sub-modules. Software components of a module may be stored on a computer readable medium for execution by a processor. Modules may be integral to one or more servers, or be loaded and executed by one or more servers. One or more modules may be grouped into an engine or an application.

One or more aspects of at least one embodiment may be implemented by representative instructions stored on a machine-readable medium which represents various logic within the processor, which when read by a machine causes the machine to fabricate logic to perform the techniques described herein. Such representations, known as "IP cores," may be stored on a tangible, machine readable medium and supplied to various customers or manufacturing facilities to load into the fabrication machines that make the logic or processor. Of note, various embodiments described herein may, of course, be implemented using any appropriate hardware and/or computing software languages (e.g., C++, Objective-C, Swift, Java, JavaScript, Python, Perl, QT, and the like).

For example, exemplary software specifically programmed in accordance with one or more principles of the present disclosure may be downloadable from a network, for example, a website, as a stand-alone product or as an add-in package for installation in an existing software application. For example, exemplary software specifically programmed in accordance with one or more principles of the present disclosure may also be available as a client-server software application, or as a web-enabled software application. For example, exemplary software specifically programmed in accordance with one or more principles of the present disclosure may also be embodied as a software package installed on a hardware device.

For the purposes of this disclosure the term "user", "subscriber" "consumer" or "customer" should be understood to refer to a user of an application or applications as described herein and/or a consumer of data supplied by a data provider. By way of example, and not limitation, the term "user" or "subscriber" can refer to a person who receives data provided by the data or service provider over the Internet in a browser session, or can refer to an automated software application which receives the data and stores or processes the data. Those skilled in the art will recognize that the methods and systems of the present disclosure may be implemented in many manners and as such are not to be limited by the foregoing exemplary embodiments and examples. In other words, functional elements being performed by single or multiple components, in various combinations of hardware and software or firmware, and individual functions, may be distributed among software applications at either the client level or server level or both. In this regard, any number of the features of the different embodiments described herein may be combined into single or multiple embodiments, and alternate embodiments having fewer than, or more than, all of the features described herein are possible.

Functionality may also be, in whole or in part, distributed among multiple components, in manners now known or to become known. Thus, myriad software/hardware/firmware combinations are possible in achieving the functions, features, interfaces and preferences described herein. Moreover, the scope of the present disclosure covers conventionally known manners for carrying out the described features and functions and interfaces, as well as those variations and modifications that may be made to the hardware or software or firmware components described herein as would be understood by those skilled in the art now and hereafter.

Furthermore, the embodiments of methods presented and described as flowcharts in this disclosure are provided by way of example in order to provide a more complete understanding of the technology. The disclosed methods are not limited to the operations and logical flow presented herein. Alternative embodiments are contemplated in which the order of the various operations is altered and in which sub-operations described as being part of a larger operation are performed independently.

While various embodiments have been described for purposes of this disclosure, such embodiments should not be deemed to limit the teaching of this disclosure to those embodiments. Various changes and modifications may be made to the elements and operations described above to obtain a result that remains within the scope of the systems and processes described in this disclosure.

**Claims**

1. A method comprising:

   encoding, by a first device, a set of data samples, the encoding comprising determining a delta between consecutive values among the data samples;
   compressing, by the first device, the encoded set of data samples into a data value, the compression being in accordance with a variable storage element size and a static code word size;
   communicating, by the first device over a network to a second device, the data value, the data value comprising a configuration and sequence of the set of data samples based on the compression; and
   storing, based on the communication, the data value based on information related to the variable storage element size and the static code word.

2. The method of claim 1, wherein the compression further comprises:

   determining, by the first device, a type of variable storage element size; and
   executing, by the first device, a signedness operation for the data value based on the determined type of variable storage element size.

3. The method of claim 1, wherein the data value is decompressed by the second device upon receipt, wherein the decompressed data value is stored in a buffer associated with the second device.

4. The method of claim 3, wherein the decompressed data value is communicated to a cloud storage.

5. The method of claim 1, wherein the first device and the second device are communicatively connected via the network.

6. The method of claim 1, further comprising:

   identifying a data set associated with the first device; and
   sampling the identified set, wherein the set of data samples are based on the sampling.

7. The method of claim 1, wherein the data set comprises information indicating measurements of operations of the first device for a predetermined time period.

8. The method of claim 1, wherein the network is a specifically configured network for communication between the first and second devices.

9. The method of claim 1, further comprising:
causing the second device to perform an operation based on the received data value.

10. The method of claim 1, wherein the second device is a thermostat at a location, wherein the thermostat controls a third device based on the received data value.

11. The method of claim 1, wherein the second device is a communication gateway at a location, the communication gateway comprising functionality for sending received data to a cloud.

12. The method of claim 1, wherein the first device is an equipment interface module.

13. The method of claim 1, wherein the first device is a sensing device at a location.

14. A device comprising:
a processor configured to:

encode a set of data samples, the encoding comprising determining a delta between consecutive values among the data samples;
compress the encoded set of data samples into a data value, the compression being in accordance with a variable storage element size and a static code word size;
communicate, over a network to a second device, the data value, the data value comprising a configuration and sequence of the set of data samples based on the compression; and
store, based on the communication, the data value based on information related to the variable storage element size and the static code word.

15. The device of claim 14, wherein the processor is further configured to:

determine a type of variable storage element size; and
execute a signedness operation for the data value based on the determined type of variable storage element size.

16. The device of claim 14, wherein the data value is decompressed by the second device upon receipt, wherein the decompressed data value is stored in a buffer associated with the second device.

17. A non-transitory computer-readable storage medium tangibly encoded with computer-executable instructions that when executed by a system, perform a method comprising:

encoding, by a first device, a set of data samples, the encoding comprising determining a delta between consecutive values among the data samples;
compressing, by the first device, the encoded set of data samples into a data value, the compression being in accordance with a variable storage element size and a static code word size;
communicating, by the first device over a network to a second device, the data value, the data value comprising a configuration and sequence of the set of data samples based on the compression; and
storing, based on the communication, the data value based on information related to the variable storage element size and the static code word.

18. The non-transitory computer-readable storage medium of claim 17, wherein the compression further comprises:

determining, by the first device, a type of variable storage element size; and
executing, by the first device, a signedness operation for the data value based on the determined type of variable storage element size.

19. The non-transitory computer-readable storage medium of claim 17, wherein the data value is decompressed by the second device upon receipt, wherein the decompressed data value is stored in a buffer associated with the second device.

**20.** The non-transitory computer-readable storage medium of claim 17, further comprising:
causing the second device to perform an operation based on the received data value.

FIG. 1

Communication Engine 200

Compression module

202

Storage module

206

Decompression module

204

Output module

208

FIG. 2

300

302 Identify a data set

304 Perform delta encoding

306 Perform compression of the data set

308 Communicate, by a first device, the compressed data set

310 Store information related to the communicated data set

312 Receive, by second device, the compressed data

314 Decompress the received data

316 Store the decompressed data

318 Execute an operation via the second device

FIG. 3

FIG. 4

| | |
|---|---|
| | **Web Browser, Mobile App, Thin Client, Terminal Emulator, ...** <br> **504** |
| Application | **SaaS** <br> CRM, Email, Virtual Desktop, Communication, Games, ... <br> **506** |
| Platform | **PaaS** <br> Execution Runtime, Database, Web Server, Development Tools, ... <br> **508** |
| Infra-structure | **IaaS** <br> Virtual Machines, Servers, Storage, Load Balancers, Network, ... <br> **510** |

# FIG. 5

FIG. 6

Europäisches
Patentamt

European
Patent Office

Office européen
des brevets

# EUROPEAN SEARCH REPORT

Application Number

EP 24 16 1255

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GIORGI GIADA: "Lightweight Lossless Compression for $N$ -Dimensional Data in Multi-Sensor Systems", IEEE SENSORS JOURNAL, IEEE, USA, vol. 19, no. 19, 1 October 2019 (2019-10-01), pages 8895-8903, XP011744236, ISSN: 1530-437X, DOI: 10.1109/JSEN.2019.2922666 [retrieved on 2019-09-04] * table II * * figure 4 * * section IV; page 4, left-hand column * * Section III.B * * section V; page 5, left-hand column * * Section VI * ----- | 1-20 | INV. H04L67/12 H03M7/30 H04L69/04 H04W4/38 H04W4/70 |
| | | | TECHNICAL FIELDS SEARCHED (IPC) |
| | | | H04L H03M H04W |

The present search report has been drawn up for all claims

| Place of search | Date of completion of the search | Examiner |
|---|---|---|
| The Hague | 10 July 2024 | Cuevas Casado, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)